Europäisches Patentamt

European Patent Office

Office européen des brevets

(19)

(11) Publication number: 0 374 274
A1

## EUROPEAN PATENT APPLICATION

(12)

(21) Application number: 88121199.9

(51) Int. Cl.⁵: G06F 15/60

(22) Date of filing: 17.12.88

(43) Date of publication of application:
27.06.90 Bulletin 90/26

(84) Designated Contracting States:
DE FR GB IT

(71) Applicant: International Business Machines
Corporation
Old Orchard Road
Armonk, N.Y. 10504(US)

(72) Inventor: Pollmann, Kurt, Dipl.-Ing.
Ulmenweg 21
D-7031 Altdorf(DE)
Inventor: Zühlke, Rainer, Dr.-Ing.
Rainstrasse 3
D-7250 Leonberg 7(DE)
Inventor: Schettler, Helmut, Dipl.-Ing.
Jägerstrasse 23
D-7405 Dettenhausen(DE)
Inventor: Keinert, Joachim, Dipl.-Ing.
Luxemburger Strasse 2
D-7030 Böblingen(DE)

(74) Representative: Herzog, Friedrich Joachim,
Dipl.-Ing.
IBM Deutschland GmbH Schönaicher
Strasse 220
D-7030 Böblingen(DE)

(54) Method for verification of VLSI-chip data.

(57) In accordance with the present invention before checking the RIT (Release Interface Tape) data of a VLSI-chip those data out of the flat chip design, existing in a nested data structure, partitions are extracted. The nested data structure is partitioned in segments of smaller size. In this segments the nested data structure is maintained. The original chip data is maintained also in the nested data structure and thus not destroyed. The segmenting is done with the help of different reference shapes which mark the boundaries of the partitions. A hierarchical verification program, called internally Nested Sigma, is used under control of a specifically designed control program macro for partitioning into the smaller segments. By means of reference shapes the nested data are divided into nested segments with RIT data contained in it. This smaller RIT segment now is in a size which can be verified and checked by the usual verification and checking programs.

FIG. 1

## Method for Verification of VLSI-Chip Data

The invention relates to a method for the verification of the data of a physically designed very large scale integrated (VLSI) chip, especially for a non-segmented chip, where chip data before checking are released from a nested data structure and where this structure would be resolved after checking by the currently available verification and checking programs.

European Patent Application 0 271 596 A1 pertains to a method for physical VLSI-Chip design. For the physical design of a VLSI chip a method is provided to implement a high density master image that contains logic and RAMs. In a hierarchical top-down design methodology the circuitry to be contained on the chip is logically divided into partitions that are manageable by the present automatic design systems and programs. Global wiring connection lines are from the beginning included into the design of the different individual partitions and treated there in the same way as circuits in that area. Thus the different partitions are designed in parallel. A floorplan is established that gives the different partitions a shape in such a way that they fit together without leaving any space between the different individual partitions. The chip need no extra space for global wiring and the partitions are immediately attached to each other. The master image described is very flexible with respect to logic, RAM, ROM and other macros, and it offers some of the advantages of semicustom gate arrays and custom macro design. The thus designed chip shows no global wiring avenues between the partitions and has partitions of different porosity.

This described partitioning scheme in the physical design of a VLSI-chip includes that the different partitions can be designed and manipulated essentially independent of what is done in the neighbouring partitions. That also would mean that checking and verification can be done independently. For this checking and verification the currently available appropriate programs are used.

It is well foreseeable that the next VLSI-chip generation being threefold as dense as the current one, will be generated in an automated design process for providing the manageability of such complex chips to a large number of users. By such a chip generated with the help of electronic design system programs, so called EDS programs, in a flat design no segmentizing is possible anymore. That also means that the chip cannot be checked and verified anymore completely. The reason for that is that the chip data consists of a nested data structure and after the check the structure is resolved by the current checking programs. In this unnesting process an enormous increase in the amount of data is incorporated. This increase is not manageable by the current verification and checking programs.

It is therefore the object of the present invention to provide a way and to provide means that makes it possible to verify and check chips generated in a so called flat and automated design process.

· In advantageous manner this object is solved basically by the features as laid down in the characterizing clause of main claim 1. Further developments of this basic solution are laid down in the dependent subclaims.

In advantageous manner the release interface tape (RIT) data of the chip, generated out of the flat chip design in a nested data structure, are divided advantageously into partitions. So the nested data structure of the complete chip is partitioned in segments of smaller size. In these segments the nested data structure is maintained as well as the nested structure is maintained in the original chip data. The so provided smaller RIT segments are now available in a size in which they can be verified and checked by the usual and currently available appropriate verification and checking programs.

The advantage is that larger chips are again verifiable, that shapes can be manipulated under maintaining the nested data structure, that a higher data integrity is possible and that also incremental processing is possible which means that the original data as well as those derived from them as increments can be manipulated. Finally a reduction of CPU (Central Processing Unit) cost for verification and checking by a factor of ten to a hundred is possible.

The above and other objects, features and attainments of the present invention will become more apparent for those skilled in the art upon reading the following detailed description taken in conjunction with the accompanying drawing which show an illustrative embodiment of the invention and in which

Fig. 1 shows schematically a chip having different partitions PT1 to PTn and an I/O area on the outside;

Fig. 2 shows a flow chart incorporating the invention;

Fig. 3 shows a figurative illustration of the partitioning or segmenting respectively of the chip in accordance with the present invention as performed by the control program macro of Fig. 2; and

Fig. 4 shows the GL/1 chip structure after the application of the present invention.

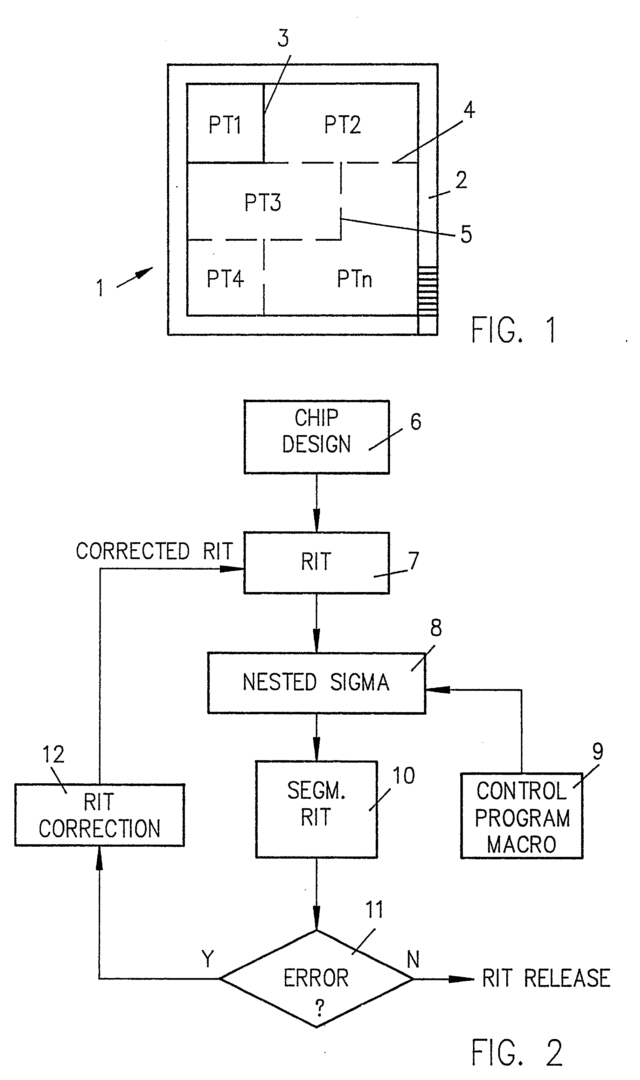

In Fig. 1 there is shown schematically a chip 1 having a surrounding I/O area 2 in which the input/output drivers are located. Inside this I/O area 2 there are shown different partitions PT1, PT2, PT3, PT4 and PTn.

These areas PT1 to PTn symbolize in this schematical representation different partitions in which the whole flat chip design is divided or segmented respectively. As can be seen from Fig. 1 the shapes of the different pieces of the different partitions PT1 to PTn are different. The different borderlines 3, 4, 5 for example cut out differently shaped partitions out of the flat chip design. As the flat chip design usually contained books that follow a certain design grid, the borderlines 3, 4 or 5 follow those provided grid lines. The chip design is preferably divided along those book borderlines into the different segments. In accordance with the present invention a chip flat approach containing for example 60 000 to 100 000 books are divided in pieces or partitions that have a manageable size of books. The manageability is given by the currently available appropriate checking and verification programs and the given CPU power. In accordance with those prerequisits the different sizes of the different partitions and pieces can be chosen adequately.

In the flowchart of Fig. 2 the handling of the verification and checking process of a very large scale chip design under inclusion of the present invention is explained in more detail. Block 6 designates the chip design which results in RIT data, also called GL/1 data, shown by block 7. RIT stands for Release Interface Tape and those data of the chip are going to be delivered to manufacturing after the physical chip design has performed. Those RIT data are so-called nested data. Nested data is the designation of data that are given by their relative addresses. Unnested data are those data that are given by their absolute position data. For a person skilled in the art it is clear that unnested data do need much more storage capacity than nested data. A utility tool system called Nested Sigma extracts, see block 8 in Fig. 2, under the control of a Control Program Macro 9 segments out of the complete nested RIT data. Block 10 reflects this result having the new partitionized RIT data. Those segments or partitions include the data in unnested or nested structure respectively.

By the Control Program Macro 9 together with the system Nested Sigma 8 the nested data structure of the base RIT data is not dissolved or destroyed respectively thereby. This so newly formed segment RIT can now be checked in the usual way and verified if an error exists or not. This is indicated by block 11. If no error exists, the RIT data of this checked segment is released. If there exists an error a RIT correction in block 12 is performed. This RIT correction is performed in the source data that means in the nested data structure. Then the so corrected RIT data are introduced into the base RIT data at block 7.

It is obvious for a person skilled in the art that each derived segment of the RIT data is checked and verified in the usual manner by the available checking and verification programs.

TABLE 1 shows a program written in a higher program language (IBM internally called SL1) which essentially is equivalent to the flowchart shown in Fig. 2.

TABLE 1

```
//BPOLRMWA JOB (CD61,04-09),POLLMANN,NOTIFY=BPOL,
//              MSGCLASS=Q,MSGLEVEL=(1,1)
//*MAIN        ORG=RMT84,CLASS=C
//********************************************************************
//* SOURCE DATASET: SIGMA.JCL(SIGCPTRE)
//********************************************************************
//**    RUN NESTED SIGMA
//********************************************************************
//*
//JOBLIB    DD   DISP=SHR,DSN=R86.PL.QFLOCAL
//          DD   DISP=SHR,DSN=R86.PL.QF
//          DD   DISP=SHR,DSN=R86.PL.QF1
//          DD   DISP=SHR,DSN=R86.PL.QF4
//          DD   DISP=SHR,DSN=R86.CL.QF
//          DD   DISP=SHR,DSN=R86.PL.PROD
//          DD   DISP=SHR,DSN=R86.PL.PROD1
//          DD   DISP=SHR,DSN=R86.PL.PROD4
//          DD   DISP=SHR,DSN=R86.CL.PROD
//*         DD   DISP=SHR,DSN=BPOL.SIGMA.LOAD(MYPT1M1)
//          DD   DISP=SHR,DSN=BPOL.SIGMA.LOAD(MYPT1M2)
//********************************************************************
//*
//SIGMANST EXEC PGM=PXZMSL1C,REGION=16930K
//ADB       DD   DISP=NEW,DSN=&&ADB,
//               DCB=BLKSIZE=6440,UNIT=SYSDA,SPACE=(6440,(5000),,,ROUND)
//ADB       DD   DISP=OLD,DSN=BPOL.NSIGMA.SL1.ADB        <=== SIGMA ADB
//FT06F001 DD   SYSOUT=*
//SYSPRINT DD   SYSOUT=*,DCB=(LRECL=137,BLKSIZE=141,RECFM=VBA)
//SYSUDUMP DD   SYSOUT=*
//SYSIN     DD   DISP=SHR,DSN=BPOL.GL2.DATA(PT03WARR)    <=== INPUT GL/1
//GL1OUT    DD   DISP=SHR,DSN=BPOL.SIGMA.OUT1.PT03.GL1
//INPUT     DD   *
  SL1PROC:PROC;
    CALL $ADBINIT;
    CALL $QNBALIAS;
    $LSTOPT = 'WARN';
    CALL $QNBNDB;
    CALL $LVLSHPRE('M2      ','PIECE','MYPT1M2');
    CALL $NGL1OUT;
    /* CALL $NGL1OUT((1));              */
    CALL $PRINTADB ;
  END;
  /*
```

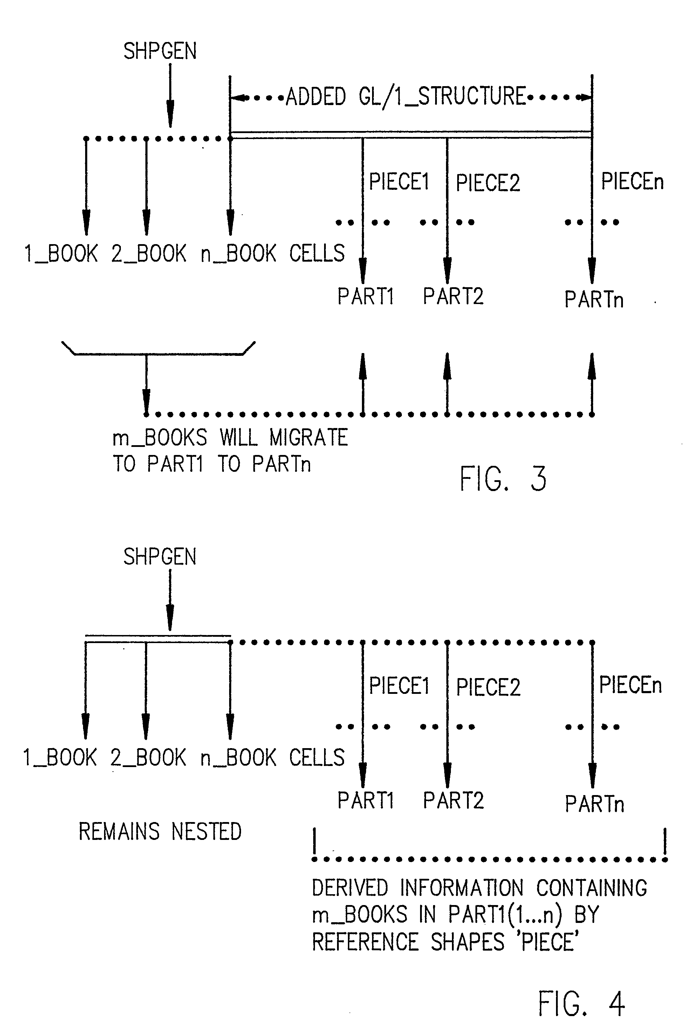

In Fig. 3 there is shown a graphical representation of the program statements contained and shown in TABLE 2. This is the application of the Control Macro Program (see block 9 in Fig. 2) for the level M2. The input GL/1_design_structure (INPUT GL/1), see left hand side in Fig. 3, will be extended by the cell_nesting_structure shown in the right hand side of Fig. 3. The function $LVLSHPRE (level shape relation extended) is applied to the mask levels of n-book cells of the flat chip design so that m-books will migrate to created partitions Part1 to Partn. Those partitions are formed by applying the different reference levels PIECE1, PIECE2 and PIECE3 for example which include the different shapes possible for different RIT segments or partitions respectively.

4

TABLE 2

```
//SYSIN   DD DISP=SHR,DSN=BPOL.GL2.DATA(PT03WARR)   <== INPUT GL/1

  SL1PROC:PROC;              \
    CALL $ADBINIT;           '==> ADB initialization
    CALL $QNBALIAS;          '
    .                        /
    .
    CALL $LVLSHPRE('M2','PIECE','MYPT1M2');
    CALL $NGL1OUT;
    .
    .
```

The Level Shape Relation function 'LVLSHPRE' finds the information necessary to process the shapes that touch external to a cell. The two input levels 'M2' and 'PIECE' are searched and the two shapes that touch (POLY1, POLY2) are found. These shapes are resolved to the common cells coordinate system (PART1 for PIECE1 and s. o.). Then 'LVLSHPRE' finds externally touching shapes, something like 'M2' touching level PIECE (1...n), it then calls the compiled user written routine (MYPT1M2) specified on the third parameter. This user written subroutine

```
  MYPT1M2:PROC(LEV1,LEV2,PATH1,POLY1,PATH1,POLY2,COMCEL)
          DCL POLYI = 'POL';
          POLYI       = POLY1;
          DO    I= 1 TO $SETBND(POLYI);
          CALL $ADDSHP(COMCEL,'LEV1',POLYI(I),PATH2);
```

will have seven parameter passed to it:
LEV1 = ⇒ M2
LEV2 = ⇒ PIECE
PATH1 = ⇒ transform PATH1
POLY1 = ⇒ M2 shapes touching polygon PIECE (1...n)
PATH2 = ⇒ transform PATH2
POLY2 = ⇒ PIECE (1...n) shapes touching M2 shapes
COMCEL = ⇒ Cell PART (1...n)

The transform paths (PATH#1 and PATH#2) and the common cell (COMCEL) are found to be used for adding the manipulated shapes (touching shapes) into the common and/or lower cells.

The incremental Shape Addition function ($ADDSHP) will write to the ADB (application data base) all shapes with input coordinates (POLYI(I)) and level 'M2' into the enabled cells (COMCELL → PART (1...n)). Returning to the procedure will call the GL/1 output function '$NGL1OUT'. A value of one (1) indicates that only the derived information will be output to GL/1.

What has been shown so far for the M2 level has to be repeated for all levels. There might be as many as 20 levels in a chip design and they could be designated as indicated by "('NW', 'RX', ..., 'NV', 'PV', ..., 'M2') in TABLE 3.

TABLE 3 indicates how a complete generalized partitioning Program could look like:

5

TABLE 3

```
SL1PROC:REPART;
   CAll $ADBINIT;        '==> ADB initialization
   CALL $QNBALIAS;       '
       .                 /
       .
   PIECE --> 'PIECE1','PIECE2',.........'PIECEn';
   LEVELS--> 'NW','RX',.............'NV','PV',...'M2';
   DO    I= 1 TO $SETBND(LEVELS);
      DO    K= 1 TO $SETBND(PIECE );
   CALL $LVLSHPRE('LEVELS(I)','PIECE(K)','MYBIF');
   END;
      END;
   CALL $NGL1out;
       .
       .
   END;


   MYBIF:PROC(LEV1,LEV2,PATH1,POLY1,PATH1,POLY2,COMCEL)
        DCL POLYI = 'POL';
        POLYI      = POLY1;
        DO    I= 1 TO $SETBND(POLYI);
        CALL $ADDSHP(COMCEL,'LEV1',POLYI(I),PATH2);
```

## Claims

1. Method for the verification of the data of a physically designed very large scale integrated chip (1), especially for a non-segmented chip, where chip data before checking are released from a nested data structure and where said structure would be dissolved after checking by the current verification and checking programs, characterized in that
    a) the overall data (RIT) of the chip (1) is divided in partitions (PT1-PTn),
    b) said partitions having marked boundaries (3,4,5),
    c) said partitions are formed by using certain reference shapes (PIECE1, 2, 3,...n),
    d) said dividing is performed such that the nested data structure of the overall data of the chip is maintained in the segments formed within said partitions, and
    e) said segments, being now small enough, are checked and verified by said verification and checking programs.

2. Method as in claims 1, wherein different reference shapes for forming said partitions are used, having real and symbolic areas.

3. Method as in claims 1 or 2, wherein a hierarchical verification program (Nested Sigma 8) performs the segmenting of the data under maintaining the nested data structure, and that a programmed program macro (9) controls said segmenting in accordance with the appropriate reference shapes.

4. Very large scale integrated chip characterized in that
its production data were generated under·the application of the method as laid down in anyone of the claims 1 - 3.

5. Very large scale integrated chip, characterized in that
its production data were partitioned into segments of manageable size before checking and/or verification was performed.

6. Very large scale integrated chip, as of claim 5 wherein said partitioning was performed by the application of the method as laid down in anyone of the claims 1 - 3.

FIG. 1

FIG. 2

SHPGEN

←·····ADDED GL/1_STRUCTURE·····→

PIECE1    PIECE2                PIECEn

1_BOOK  2_BOOK  n_BOOK CELLS

PART1    PART2                 PARTn

m_BOOKS WILL MIGRATE
TO PART1 TO PARTn

FIG. 3

SHPGEN

PIECE1    PIECE2                PIECEn

1_BOOK  2_BOOK  n_BOOK CELLS

PART1    PART2                 PARTn

REMAINS NESTED

DERIVED INFORMATION CONTAINING
m_BOOKS IN PART1(1...n) BY
REFERENCE SHAPES 'PIECE'

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| A | MICROPROCESSING & MICROPROGRAMMING, vol. 19, no. 2, February 1987, pages 85-100, Amsterdam, NL; F. GREGORETTI et al.: "Analysis and evaluation of parallel rectangle intersection for VLSI design rule checking" <br> * Page 86, column 2, line 42 - page 87, column 1, line 7, lines 43-46; page 87, column 2, lines 5-9 * <br> --- | 1,5 | G 06 F 15/60 |
| A | IEE PROCEEDINGS-G/ELECTRONIC CIRCUITS AND SYSTEMS, vol. 134, no. 2, part G, April 1987, pages 103-109, Stevenage, Herts., GB; L.G. CHEN et al.: "Hierarchical functional verification for cell-based design styles" <br> --- | | |
| A | 23rd ACM/IEEE DESIGN AUTOMATION CONFERENCE, 29th June - 2nd July 1986, pages 440-446, IEEE; P.S. HAUGE et al.: "Vanguard: A chip physical design system" <br> ----- | | |

TECHNICAL FIELDS SEARCHED (Int. Cl.5)

G 06 F 15/60

The present search report has been drawn up for all claims

| Place of search | Date of completion of the search | Examiner |
|---|---|---|
| THE HAGUE | 17-08-1989 | GUINGALE A. |

EPO FORM 1503 03.82 (P0401)